(19) Europäisches Patentamt
European Patent Office
Office européen des brevets

(11) EP 1 286 471 B1

(12) **EUROPÄISCHE PATENTSCHRIFT**

(45) Veröffentlichungstag und Bekanntmachung des Hinweises auf die Patenterteilung:
**05.10.2005 Patentblatt 2005/40**

(51) Int Cl.[7]: **H03M 7/30**

(21) Anmeldenummer: **02015138.7**

(22) Anmeldetag: **06.07.2002**

(54) **Verfahren zur Kompression von Daten**

Method for compressing data

Méthode de compression de données

(84) Benannte Vertragsstaaten:
**AT BE BG CH CY CZ DE DK EE ES FI FR GB GR IE IT LI LU MC NL PT SE SK TR**

(30) Priorität: **21.08.2001 DE 10140993**

(43) Veröffentlichungstag der Anmeldung:
**26.02.2003 Patentblatt 2003/09**

(73) Patentinhaber: **Deutsche Telekom AG**
**53113 Bonn (DE)**

(72) Erfinder:
- **Baumgart, Matthias**
  **35390 Giessen (DE)**
- **Huber, Klaus, Dr.**
  **64283 Darmstadt (DE)**
- **Windirsch, Peter, Dr.**
  **63303 Dreieich (DE)**
- **Schaffelhofer, Ralf**
  **64285 Darmstadt (DE)**
- **Schneider, Tim**
  **64295 Darmstadt (DE)**

(56) Entgegenhaltungen:
**EP-A- 0 679 033** **GB-A- 2 360 917**

- **KEATING S ET AL: "Improved lossless compression of general data" ELECTRONICS LETTERS, IEE STEVENAGE, GB, Bd. 36, Nr. 25, 7. Dezember 2000 (2000-12-07), Seiten 2070-2072, XP006016013 ISSN: 0013-5194**
- **NUNEZ J L ET AL: "A 100MBYTES/S PROASIC-BASED LOSSLESS DATA COMPRESSOR" ELECTRONIC ENGINEERING, MORGAN-GRAMPIAN LTD. LONDON, GB, Bd. 73, Nr. 888, Januar 2001 (2001-01), Seiten 69-70, XP001014272 ISSN: 0013-4902**
- **SADEH I: "On approximate string matching" DATA COMPRESSION CONFERENCE, 1993. DCC '93. SNOWBIRD, UT, USA 30 MARCH-2 APRIL 1993, LOS ALAMITOS, CA, USA,IEEE COMPUT. SOC, US, 30. März 1993 (1993-03-30), Seiten 148-157, XP010031837 ISBN: 0-8186-3392-1**
- **ZIV J ET AL: "COMPRESSION OF INDIVIDUAL SEQUENCES VIA VARIABLE-RATE CODING" IEEE TRANSACTIONS ON INFORMATION THEORY, IEEE INC. NEW YORK, US, Bd. IT-24, Nr. 5, September 1978 (1978-09), Seiten 530-536, XP000565213 ISSN: 0018-9448**
- **ZIV J ET AL: "A UNIVERSAL ALGORITHM FOR SEQUENTIAL DATA COMPRESSION" IEEE TRANSACTIONS ON INFORMATION THEORY, IEEE INC. NEW YORK, US, Bd. IT-23, Nr. 3, Mai 1977 (1977-05), Seiten 337-343, XP000828454 ISSN: 0018-9448**
- **RYABKO, B.: "Fast enumerative source coding" PROCEEDINGS OF THE 1995 IEEE INTERNATIONAL SYMPOSIUM ON INFORMATION THEORY, 17. Oktober 1995 (1995-10-17), Seiten 395-395, XP010192408 WHISTLER, BC, CAN**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 286 471 B1

Printed by Jouve, 75001 PARIS (FR)

## Beschreibung

Die Erfindung betrifft ein Verfahren zur Kompression von Daten, wobei in einem aus Zeichen bestehenden Datenstrom Zeichenfolgen auf Korrelation mit in einem vorgegebenen Abstand im Datenstrom vorhandenen anderen Zeichenfolgen geprüft werden und wobei jeweils die Anzahl von korrelierenden Zeichen und die Position der korrelierenden Zeichen innerhalb der jeweils anderen Zeichenfolge die komprimierten Daten bilden, wobei bei der Prüfung auf Korrelation die Abweichung mindestens eines Zeichens zugelassen wird und wobei zusätzlich Daten zur Korrektur des mindestens einen abweichenden Zeichens in die komprimierten Daten eingefügt werden.

Um Daten effizient übertragen oder speichern zu können, werden Verfahren zur Kompression der Daten angewandt. Bei diesen Verfahren wird zwischen verlustfreien und verlustbehafteten Kompressionsverfahren unterschieden. Die verlustfreien Verfahren zeichnen sich dadurch aus, dass eine vollständige Konstruktion der Originaldaten aus den komprimierten Daten möglich ist. Bei verlustbehafteten Verfahren dagegen ist eine vollständige Rekonstruktion der Originaldaten nicht sichergestellt.

Kompressionsverfahren mit dem Ziel einer Verringerung der jeweiligen Datenmenge werden in vielfältiger Form in der Daten- und Nachrichtentechnik eingesetzt, beispielsweise beim digitalen Fernsehen oder bei der elektronischen Kommunikation.

Auch im Zusammenhang mit der Verschlüsselung von Daten werden Kompressionsverfahren angewandt, wobei der Quelltext vor der Verschlüsselung komprimiert wird und somit eine Kryptoanalyse aufgrund geringerer Redundanz erschwert wird.

Verfahren nach der Gattung des Hauptanspruchs werden als Lempel-Ziv-Verfahren bezeichnet. Eines dieser Verfahren ist bekanntgeworden durch Ziv J., Lempel A. "A Universal Algorithm for Sequential Data Compression", IEEE Transactions on Information Theory, Vol. 23, No. 3, May 1977, pp. 337-343.

Ferner wird in KEATING S ET AL: "Improved lossless compression of general data" ELECTRONICS LETTERS, IEE STEVENAGE, GB, vol. 36, no. 25, 7 December 2000 (2000-12-07), pages 2070-2072, XP006016013 ISSN: 0013-5194 erläutert, dass eine neue Zeichenfolge nach dem Eintreffen mit jeder bereits gespeicherten Zeichenfolge verglichen wird und korrelierende Zeichenfolgen identifiziert werden, für die eine Codierung mit Hilfe einer Startadresse und einer Länge erfolgt. Bei dem Vergleich werden eine Anzahl von geringstwertigen Binärstellen nicht berücksichtigt, so dass häufigere und längere Korrelationen für verrauschte Bilder auftreten. Durch die direkte Codierung der geringstwertigen Binärstellen wird jedoch der Vorteil des auf der Korrelation von Zeichenfolgen beruhenden Codierverfahrens geschmälert.

In NUNEZ J L ET AL: "A 100MBYTES/S PROASIC-BASED LOSSLESS DATA COMPRESSOR" ELECTRONIC ENGINEERING, MORGAN-GRAMPIAN LTD. LONDON, GB, vol. 73, no. 888, January 2001 (2001-01), pages 69-70, XP001014272 ISSN: 0013-4902 wird ferner ein Verfahren beschrieben, bei dem zur Kompression von Daten Zeichenfolgen auf Korrelation mit im vorherigen Datenstrom vorhandenen und in einem Code-Buch gespeicherten anderen Zeichenfolgen geprüft werden. Dabei werden ebenfalls abweichende Zeichen zugelassen, die derart codiert werden, dass bei einem abweichenden Zeichen nur die Information über die Position in den Datenstrom eingefügt wird, während bei Zeichen, die mehr als zwei Werte annehmen können, zusätzlich der wahre Wert des mindestens einen abweichenden Zeichens eingefügt wird.

Aufgabe der vorliegenden Erfindung ist es, ein Verfahren zur Kompression von Daten anzugeben, das eine höhere Kompressionsrate aufweist, wobei der Kompressionsgewinn möglichst wenig durch die zusätzlichen Informationen geschmälert wird.

Diese Aufgabe wird erfindungsgemäß dadurch gelöst, dass zur Codierung der Positionen der abweichenden Zeichen ein komprimierender Code derart verwendet wird, dass Binärvektoren der Länge n mit dem Gewicht e zur Codierung von e Positionen von abweichenden Zeichen auf einer Länge von n verwendet werden, wobei alle Binärvektoren eines bestimmten Gewichts nummeriert werden.

Die Erfindung nutzt in vorteilhafter Weise aus, dass durch Zulassen von "Fehlern" bei der Prüfung auf Korrelation die Anzahl von korrelierenden Zeichen im Mittel höher als bei einer exakten Prüfung ist und somit mit den Informationen über Anzahl und Position im Mittel längere Folgen von Zeichen codiert werden können. Je nach Eigenschaft der zu komprimierenden Daten kann die Anzahl der zugelassenen abweichenden Zeichen gewählt werden.

Zeichen, welche den Datenstrom bilden, können bei dem erfindungsgemäßen Verfahren verschiedener Art sein. So kommen beispielsweise Zeichen, die viele Werte annehmen können, oder Binärzeichen in Frage.

Bei vorteilhaften Ausgestaltungen des erfindungsgemäßen Verfahrens ist vorgesehen, dass bei Zeichen, die mehr als zwei Werte annehmen können, zusätzlich der wahre Wert des mindestens einen abweichenden Zeichens oder dass bei Zeichen, die mehr als zwei Werte annehmen können, zusätzlich eine Vorschrift zur Ermittlung des wahren Wertes aus dem Wert des abweichenden Zeichens eingefügt wird.

Diese Vorschrift kann beispielsweise bei der Kompression von Textdaten darin bestehen, daß ein Wort oder ein Wortteil als korrelierend mit einem an sich gleichen Wort oder Wortteil angesehen wird, bei dem jedoch - beispielsweise am Satzanfang - anstelle eines kleinen ein großer Buchstabe vorkommt. Anstelle des wahren Wertes - beispielsweise großes D - braucht dann nur eine Vorschrift zur Änderung des kleinen d bei der Dekompression in die komprimierten Daten eingefügt zu werden - im Beispiel: setze an die Stelle des kleinen Buchstabens den entsprechenden großen Buchstaben!

Eine andere Ausgestaltung besteht darin, dass bei Zeichen, die Binärzeichen sind, zur Kennzeichnung der abweichenden Zeichen nur deren Position eingefügt wird.

Um die mit dem erfindungsgemäßen Verfahren komprimierten Daten gegen zufällig auftretende Fehler bei Übertragung oder Speicherung zu sichern, kann das erfindungsgemäße Verfahren derart weitergebildet sein, dass die komprimierten Daten unter Hinzufügung von Redundanz fehlerkorrigierend codiert werden. Dabei kann vorgesehen sein, dass der fehlerkorrigierende Code ein Blockcode oder ein Faltungscode ist. Geeignete Blockcodes sind dabei Reed-Solomon-Codes und Hamming-Codes.

Vorzugsweise ist bei dem erfindungsgemäßen Verfahren vorgesehen, dass die Länge der komprimierten Daten ein Vielfaches von 8 Bit beträgt. Dadurch ist eine einfache Anpassung an andere Datenverarbeitungsverfahren und an geeignete Einrichtungen möglich.

Das erfindungsgemäße Verfahren kann mit Hilfe von programmierbaren Einrichtungen (Mikroprozessoren, Mikrocontroller) und geeigneten Programmen sowie mit an das erfindungsgemäße Verfahren angepasster Hardware durchgeführt werden.

Ausführungsbeispiele der Erfindung sind in der Zeichnung anhand mehrerer Figuren dargestellt und in der nachfolgenden Beschreibung näher erläutert. Es zeigt:

Fig. 1 eine schematische Darstellung eines Lempel-Ziv-Verfahrens,

Fig. 2 eine schematische Darstellung eines Ausführungsbeispiels des erfindungsgemäßen Verfahrens,

Fig. 3 ein weiteres Ausführungsbeispiel und

Fig. 4 ein Ausführungsbeispiel einer anschließenden fehlerkorrigierenden Codierung.

Sowohl bei dem Lempel-Ziv-Verfahren als auch bei dem erfindungsgemäßen Verfahren werden die zu komprimierenden Daten in Pfeilrichtung in ein aus zwei Teilen 1, 2 bestehendes Schieberegister eingeschrieben - und zwar zunächst in den Teil 2. Der Teil 1 ist mit einem geeigneten Anfangswert belegt. Für diese Zwecke kann beispielsweise angenommen werden, dass die Anfangswerte aller im Teil 1 befindlichen Zeichen gleich 0 sind. Bei dem Lempel-Ziv-Verfahren wird nun geprüft, ob die am Anfang des Teils 2 beginnende Zeichenfolge bereits im Teil 1 vorhanden ist. Ist dies der Fall, so wird die Position innerhalb des Teils 1, an der diese Zeichenfolge beginnt, codiert. In die komprimierten Daten 3 wird ferner die Anzahl 1 der korrelierenden Zeichen bzw. die Länge der korrelierten Sequenz eingefügt. Schließlich wird das erste Zeichen der am Anfang des Teils 2 beginnenden Sequenz, das nicht im Teil 1 vorhanden ist, als sogenanntes Innovationssymbol i angefügt. Das Innovationssymbol i garantiert die Funktionsweise des Verfahrens im Falle, dass die im Teil 2 beginnende Sequenz nicht im Teil 1 vorkommt. Die Position p, die Länge 1 und das Innovationssymbol i bilden ein Codewort 3 (komprimierte Daten) und können gespeichert oder übertragen werden.

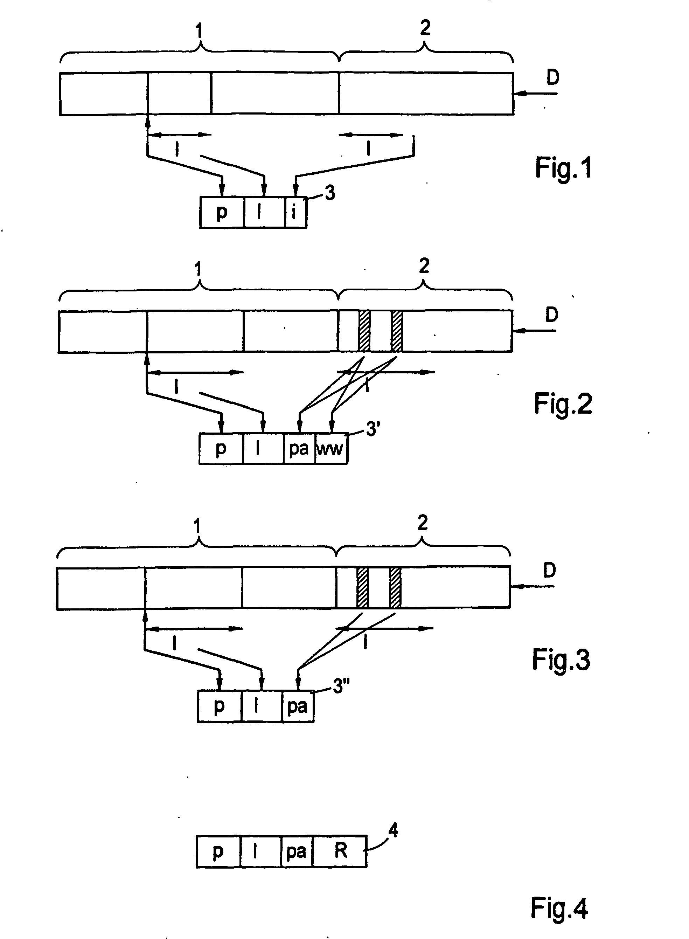

Bei dem erfindungsgemäßen Verfahren werden die zu komprimierenden Daten ebenfalls in ein aus zwei Teilen 1, 2 bestehendes Schieberegister eingeschrieben. Bei der anschließenden Prüfung werden jedoch zwei abweichende Zeichen zugelassen, die in Fig. 2 schraffiert dargestellt sind. Die Anzahl der somit als korrelierend geltenden Zeichen ist größer als bei dem Beispiel des bekannten Verfahrens in Fig. 1. Das zu speichernde oder zu übertragende Codewort 3' enthält wiederum die Position p und die Anzahl 1 der als korrelierend geltenden Zeichen. Zusätzlich sind die Positionen pa der abweichenden Zeichen und die wahren Werte ww der abweichenden Zeichen im Codewort vorgesehen.

Bei der Dekompression erfolgen die erläuterten Schritte im umgekehrten Sinne. Mit den im Codewort enthaltenen Informationen p, l wird aus den zeitlich vorangegangenen bereits dekomprimierten Daten eine Zeichenfolge entnommen und den dekomprimierten Daten hinzugefügt. Bei der Dekompression nach dem erfindungsgemäßen Verfahren werden diese Schritte ebenfalls durchgeführt. Zusätzlich erfolgt eine Korrektur der abweichenden Zeichen mit den im Codewort 3' enthaltenen Informationen pa und ww.

Bei dem Ausführungsbeispiel nach Fig. 3 werden binäre Zeichen vorausgesetzt, so dass im zu speichernden bzw. zu übertragenden Codewort 3" lediglich die Fehlerpositionen enthalten sind, so dass durch eine Invertierung der Zeichen an diesen Positionen wieder die wahren Werte gewonnen werden können.

Bei der Codierung von e Positionen abweichender Zeichen - im folgenden auch Fehler genannt - auf einer Länge von n benutzt man am besten Binärvektoren der Länge n mit Gewicht e. Bei der Codierung kann man effiziente Verfahren benutzen, um alle Binärvektoren eines bestimmten Gewichts zu nummerieren, siehe z.B. Cover, T.: "Enumerative Source Coding", IEEE Transactions on Information Theory, Vol. 19, No. 1, January 1973, pp. 73-77*. Auf diese Weise werden die Positionen optimal, d.h. mit minimaler Anzahl von Bits, codiert.

Dabei erfolgt die Codierung der Fehlerpositio-

* oder Ryabko, B.: "Fast enumerative source coding", Proceedings of the 1995 IEEE International Symposium on Information Theory, 17. Oktober 1995 (1995-10-17), Seite 395, XP010192408, Whistler, BC, Canada

nen mittels $\log_2\binom{n}{e}$ Bit, wobei nach oben zur nächsten ganzen Zahl zu runden ist. Zum Beispiel gibt es im Fall e=2 $\binom{n}{2}$ = n·(n-1)/(1·2) = n·(n-1)/2 Möglichkeiten, wie die Zeichen angeordnet sein können. Um die Fehler zu charakterisieren, benötigt man bei zwei Fehlern also nicht $2\log_2 n$ Bits, sondern ein Bit weniger. Dieses Bit kann man je nach Randbedingungen beispielsweise zur Fehlerkorrektur benutzen. Im allgemeinen Fall bei der Korrektur mit e Fehlern benötigt man zur Codierung von allen Fehlermustern $\log_2\binom{n}{e}$ Bit, wobei nach oben zur nächsten ganzen Zahl zu runden ist. Dies ist eine optimale Codierung der Fehlermuster, d.h. die Codierung kann nicht mit weniger Bit erfolgen. Für die Umwandlung der Fehlermuster in gängige Darstellungen gibt es effiziente Algorithmen, wie sie beispielsweise von T. Cover beschrieben wurden.

Ist das betrachtete Alphabet binär, d.h. gleich {0,1}, so kann auf die Angabe der Fehlerwerte, die dann natürlich gleich eins sind, verzichtet werden. Der Binärfall ist in Fig. 3 dargestellt. Im Binärfall kann man verschiedene Fälle betrachten. Zum einen kann das betrachtete Alphabet des Datenstroms binär sein. Zum anderen ist es aus Effizienzgründen auch möglich, einen nichtbinären Datenstrom zu betrachten und nur die Fehlerpositionen im zu speichernden Codewort binär zu codieren.

Fig. 4 deutet eine Erweiterung des zu speichernden Codewortes mit Redundanz R an, die zur Fehlersicherung bei der Übertragung oder Speicherung des Codewortes 4 dient. Es wird die Benutzung eines sogenannten Blockcodes zur Fehlerkorrektur symbolisiert. Hier sind insbesondere Reed-Solomon-, Hamming- und eventuell auch BCH-Codes von Interesse. Es können aber auch sogenannte Faltungscodes in Betracht gezogen werden. Von Vorteil ist bei den hier beschriebenen Verfahren die Möglichkeit der Optimierung der einzelnen Größen, insbesondere dergestalt, dass als Speichergröße des gesamten Codewortes ein in der Praxis günstiges Format, wie Vielfache von 8 Bits (8 Bit=1 Byte), gewählt werden kann.

## Patentansprüche

1. Verfahren zur Kompression von Daten, wobei in einem aus Zeichen bestehenden Datenstrom Zeichenfolgen auf Korrelation mit in einem vorgegebenen Abstand im Datenstrom vorhandenen anderen Zeichenfolgen geprüft werden, wobei jeweils die Anzahl von korrelierenden Zeichen und die Position der korrelierenden Zeichen innerhalb der jeweils anderen Zeichenfolge die komprimierten Daten bilden, wobei bei der Prüfung auf Korrelation die Abweichung mindestens eines Zeichens zugelassen wird und wobei zusätzlich Daten zur Korrektur des mindestens einen abweichenden Zeichens in die komprimierten Daten eingefügt werden, **dadurch gekennzeichnet, dass** zur Codierung der Positionen der abweichenden Zeichen ein komprimierender Code derart verwendet wird, dass Binärvektoren der Länge n mit dem Gewicht e zur Codierung von e Positionen von abweichenden Zeichen auf einer Länge von n verwendet werden, wobei alle Binärvektoren eines bestimmten Gewichts nummeriert werden.

2. Verfahren nach Anspruch 1, **dadurch gekennzeichnet, dass** bei Zeichen, die mehr als zwei Werte annehmen können, zusätzlich der wahre Wert des mindestens einen abweichenden Zeichens eingefügt wird.

3. Verfahren nach Anspruch 1, **dadurch gekennzeichnet, dass** bei Zeichen, die mehr als zwei Werte annehmen können, zusätzlich eine Vorschrift zur Ermittlung des wahren Wertes aus dem Wert des abweichenden Zeichens eingefügt wird.

4. Verfahren nach Anspruch 1, **dadurch gekennzeichnet, dass** bei Zeichen, die Binärzeichen sind, zur Kennzeichnung der abweichenden Zeichen nur deren Position eingefügt wird.

5. Verfahren nach einem der vorhergehenden Ansprüche, **dadurch gekennzeichnet, dass** die komprimierten Daten unter Hinzufügung von Redundanz fehlerkorrigierend codiert werden.

6. Verfahren nach Anspruch 5, **dadurch gekennzeichnet, dass** der fehlerkorrigierende Code ein Blockcode ist.

7. Verfahren nach Anspruch 5, **dadurch gekennzeichnet, dass** der fehlerkorrigierende Code ein Faltungscode ist.

8. Verfahren nach Anspruch 6, **dadurch gekennzeichnet, dass** der fehlerkorrigierende Code ein Reed-Solomon-Code ist.

9. Verfahren nach Anspruch 6, **dadurch gekennzeichnet, dass** der fehlerkorrigierende Code ein Hamming-Code ist.

10. Verfahren nach einem der vorhergehenden Ansprüche, **dadurch gekennzeichnet, dass** die Länge der komprimierten Daten ein Vielfaches von 8 Bit beträgt.

## Claims

1. Method for the compression of data, wherein, in a data stream consisting of characters, character strings are checked for correlation with other character strings contained at a predetermined interval in the data stream, wherein in each case the number of correlating characters and the positions of the correlating characters within the other character string form the compressed data, wherein, during the check for correlation, the deviation of at least one character is allowed and wherein data for correcting the at least one deviating character are additionally inserted into the compressed data, **characterized in that**, for coding the positions of the deviating characters, a compressing code is used in such a manner that binary vectors of length n with weight e are used for coding e positions of deviating characters over a length of n, all the binary vectors of a certain weight being numbered.

2. Method according to claim 1, **characterized in that**, in the case of characters which can assume more than two values, the true value of the at least one deviating character is additionally inserted.

3. Method according to claim 1, **characterized in that**, in the case of characters which can assume more than two values, a rule for determining the true value from the value of the deviating character is additionally inserted.

4. Method according to claim 1, **characterized in that**, in the case of characters which are binary characters, for identification of the deviating characters only the positions thereof are inserted.

5. Method according to any one of the preceding claims, **characterized in that** the compressed data are coded in error-correcting manner with the addition of redundancy.

6. Method according to claim 5, **characterized in that** the error-correcting code is a block code.

7. Method according to claim 5, **characterized in that** the error-correcting code is a convolutional code.

8. Method according to claim 6, **characterized in that** the error-correcting code is a Reed-Solomon code.

9. Method according to claim 6, **characterized in that** the error-correcting code is a hamming code.

10. Method according to any one of the preceding claims, **characterized in that** the length of the compressed data is a multiple of 8 bits.

## Revendications

1. Procédé de compression de données dans lequel, dans un flux de données composé de caractères, la corrélation est vérifiée entre des séquences de caractères et d'autres séquences de caractères se trouvant à un intervalle prédéfini dans le flux de données, les données comprimées étant constituées du nombre de caractères en corrélation et de la position des caractères en corrélation à l'intérieur de l'autre séquence de caractères, un écart d'au moins un caractère étant admis lors de la vérification de la corrélation et des données supplémentaires étant insérées dans les données comprimées pour corriger le ou les caractère(s) divergent(s), **caractérisé en ce que**, pour le codage des positions des caractères divergents, un code de compression est employé de telle façon que des vecteurs binaires de longueur n et de poids e sont utilisés pour le codage de e positions de caractères divergents sur une longueur n, tous les vecteurs binaires d'un poids déterminé étant numérotés.

2. Procédé selon la revendication 1, **caractérisé en ce que**, pour les caractères qui peuvent avoir plus de deux valeurs, la vraie valeur du ou des caractères divergents est en plus insérée .

3. Procédé selon la revendication 1, **caractérisé en ce que**, pour les caractères qui peuvent avoir plus de deux valeurs, une règle est en plus insérée, permettant de déterminer la vraie valeur à partir de la valeur du caractère divergent.

4. Procédé selon la revendication 1, **caractérisé en ce que**, pour les caractères étant des caractères binaires, seule la position des caractères divergents est insérée pour leur signalisation.

5. Procédé selon l'une des revendications précédentes, **caractérisé en ce que** les données comprimées sont codées pour correction d'erreur par addition de redondance.

6. Procédé selon la revendication 5, **caractérisé en ce que** le code de correction d'erreur est un code bloc.

7. Procédé selon la revendication 5, **caractérisé en ce que** le code de correction d'erreur est un code de convolution.

8. Procédé selon la revendication 6, **caractérisé en ce que** le code de correction d'erreur est un code Reed-Solomon.

9. Procédé selon la revendication 6, **caractérisé en ce que** le code de correction d'erreur est un code Hamming.

10. Procédé selon l'une des revendications précédentes, **caractérisé en ce que** la longueur des données comprimées est un multiple de 8 bit.

1
2
D
l
l
p l i
3

Fig.1

1
2
D
l
l
p l pa ww
3'

Fig.2

1
2
D
l
l
p l pa
3"

Fig.3

p
l
pa
R
4

Fig.4